(19) Europäisches Patentamt
European Patent Office
Office européen des brevets

(11) **EP 4 517 424 A1**

(12) **EUROPEAN PATENT APPLICATION**

(43) Date of publication:
**05.03.2025 Bulletin 2025/10**

(21) Application number: **23193729.3**

(22) Date of filing: **28.08.2023**

(51) International Patent Classification (IPC):
**G03F 7/00** (2006.01)   **G03F 9/00** (2006.01)

(52) Cooperative Patent Classification (CPC):
**G03F 7/70633; G03F 7/70466; G03F 7/70491; G03F 7/70525; G03F 9/7003**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **ASML Netherlands B.V.**
**5500 AH Veldhoven (NL)**

(72) Inventors:
• **YU, Hyunwoo**
**5500 AH Veldhoven (NL)**
• **KHO, Sinatra, Canggih**
**5500 AH Veldhoven (NL)**
• **LAMBREGTS, Cornelis, Johannes, Henricus**
**5500 AH Veldhoven (NL)**
• **BLOM, Herman, Martin**
**5500 AH Veldhoven (NL)**

(74) Representative: **ASML Netherlands B.V.**
**Corporate Intellectual Property**
**P.O. Box 324**
**5500 AH Veldhoven (NL)**

(54) **METHOD OF DETERMINING AN EXPOSURE STRATEGY, LITHOGRAPHY METHOD AND APPARATUS AND COMPUTER PROGRAM**

(57) Disclosed is a method of determining an exposure strategy for at least a first exposure in a first layer of a substrate with a first correction capability and at least a second exposure in a second layer of said substrate with a second correction capability, the second correction capability being different to the first correction capability, the method comprising: determining a first layer correctable error component of said first layer parameter of interest data, which is correctable according to said first correction capability; determining a first portion of said first layer correctable error component uncorrectable according to said second correction capability; dividing said first portion of said first layer correctable error into at least a first sub-portion and a second sub-portion; and attributing said first sub-portion to a first exposure error budget and said second sub-portion a second exposure error budget.

Fig. 10

**Description**

<u>BACKGROUND</u>

<u>FIELD OF THE INVENTION</u>

The present invention relates to methods of manufacture of devices by lithographic techniques.

<u>BACKGROUND ART</u>

A lithographic apparatus is a machine that applies a desired pattern onto a substrate, usually onto a target portion of the substrate. A lithographic apparatus can be used, for example, in the manufacture of integrated circuits (ICs). In that instance, a patterning device, which is alternatively referred to as a mask or a reticle, may be used to generate a circuit pattern to be formed on an individual layer of the IC. This pattern can be transferred onto a target portion (e.g., including part of, one, or several dies) on a substrate (e.g., a silicon wafer). Transfer of the pattern is typically via imaging onto a layer of radiation-sensitive material (resist) provided on the substrate. In general, a single substrate will contain a network of adjacent target portions that are successively patterned. In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, a measure of the accuracy of alignment of two layers in a device. Overlay may be described in terms of the degree of misalignment between the two layers, for example reference to a measured overlay of 1nm may describe a situation where two layers are misaligned by 1nm.

Recently, various forms of scatterometers have been developed for use in the lithographic field. These devices direct a beam of radiation onto a target and measure one or more properties of the scattered radiation - e.g., intensity at a single angle of reflection as a function of wavelength; intensity at one or more wavelengths as a function of reflected angle; or polarization as a function of reflected angle - to obtain a "spectrum" from which a property of interest of the target can be determined. Determination of the property of interest may be performed by various techniques: e.g., reconstruction of the target by iterative approaches such as rigorous coupled wave analysis or finite element methods; library searches; and principal component analysis.

The targets used by conventional scatterometers are relatively large, e.g., $40\mu m$ by $40\mu m$, gratings and the measurement beam generates a spot that is smaller than the grating (i.e., the grating is underfilled). This simplifies mathematical reconstruction of the target as it can be regarded as infinite. However, in order to reduce the size of the targets, e.g., to $10\mu m$ by $10\mu m$ or less, e.g., so they can be positioned in amongst product features, rather than in the scribe lane, metrology has been proposed in which the grating is made smaller than the measurement spot (i.e., the grating is overfilled). Typically such targets are measured using dark field scatterometry in which the zeroth order of diffraction (corresponding to a specular reflection) is blocked, and only higher orders processed. Examples of dark field metrology can be found in international patent applications WO 2009/078708 and WO 2009/106279 which documents are hereby incorporated by reference in their entirety. Further developments of the technique have been described in patent publications US20110027704A, US20110043791A and US20120242940A. The contents of all these applications are also incorporated herein by reference. Diffraction-based overlay using dark-field detection of the diffraction orders enables overlay measurements on smaller targets. These targets can be smaller than the illumination spot and may be surrounded by product structures on a wafer. Targets can comprise multiple gratings which can be measured in one image.

Different lithography apparatuses may have different correction capabilities, for example, depending on a correction parameterization of each respective apparatus. This difference of correction capability might mean that one or more certain correction parameters are available on one apparatus but not another. However, these different apparatuses may be used in the manufacture of a single device, i.e., to expose different layers of the device. This can result in a correctable error component of a first layer fingerprint (e.g., an overlay fingerprint) which is not fully correctable in a second layer, e.g., where the second layer is exposed on an apparatus with a different and/or more limited correction capability compared to that which exposed the first layer. The portion of this correctable error (with respect to the first layer apparatus) which cannot be corrected using the second layer apparatus can result in the second layer exposure being forced out of specification.

It would be desirable to mitigate for the effect of different correction capability of different apparatuses used in the manufacture of a single device.

<u>SUMMARY</u>

In a first aspect of the invention there is provided a method of determining an exposure strategy for at least a first exposure in a first layer of a substrate with a first correction capability and at least a second exposure in a second layer of said substrate with a second correction capability, the second correction capability being different to the first correction capability, the method comprising: obtaining first layer parameter of interest data relating to said first layer; determining a first layer correctable error component of said first layer parameter of interest data, which is correctable according to said first correction capability; determining a first portion of said first layer correctable error component, said first portion of said first layer correctable error component being correctable according to said first correction capability but uncorrectable according to said second correction capability; dividing said first portion of said first layer correctable error into at least a first sub-portion of said first portion of said first layer correctable error component and a second sub-portion of said first portion of said first layer correctable error component; and attributing said first sub-portion of said first portion of said first layer correctable error component to a first exposure error budget of said first exposure and said second sub-portion of said first portion of said first layer correctable error component to a second exposure error budget of said second exposure.

In another aspect a computer program comprising processor readable instructions which, when run on suitable processor controlled apparatus, cause the processor controlled apparatus to perform the method of the first aspect and a computer program carrier comprising such a computer program. The processor controlled apparatus may comprise a metrology apparatus or lithographic apparatus or processor therefor.

Further features and advantages of the invention, as well as the structure and operation of various embodiments of the invention, are described in detail below with reference to the accompanying drawings. It is noted that the invention is not limited to the specific embodiments described herein. Such embodiments are presented herein for illustrative purposes only. Additional embodiments will be apparent to persons skilled in the relevant art(s) based on the teachings contained herein.

BRIEF DESCRIPTION OF THE DRAWINGS

Embodiments of the invention will now be described, by way of example only, with reference to the accompanying drawings in which:

Figure 1 depicts a lithographic apparatus according to an embodiment of the invention;
Figure 2 depicts a lithographic cell or cluster according to an embodiment of the invention;
Figure 3(a) comprises a schematic diagram of a dark field scatterometer for use in measuring targets according to embodiments of the invention using a first pair of illumination apertures; Figure 3(b) illustrates a detail of diffraction spectrum of a target grating for a given direction of illumination; Figure 3(c) illustrates a second pair of illumination apertures providing further illumination modes in using the scatterometer for diffraction based overlay measurements; and Figure 3(d) illustrates a third pair of illumination apertures combining the first and second pair of apertures;
Figure 4(a) illustrates a first exposure strategy to which embodiments disclosed herein are applicable;
Figure 4(b) illustrates a second exposure strategy to which embodiments disclosed herein are applicable;
Figure 4(c) illustrates a generalized exposure strategy to which embodiments disclosed herein are applicable;
Figure 5 is an error budget diagram for two exposures in two layers of a substrate illustrating a problem which may arise from any of the exposure strategies of Figures 4(a) to 4(c);
Figure 6 schematically illustrates a design matrix implementing a cost function which may be used in a first embodiment;
Figure 7 schematically illustrates a design matrix implementing a cost function which may be used in a second embodiment;
Figure 8 schematically illustrates a design matrix implementing a cost function which may be used in a third embodiment;
Figure 9 schematically illustrates a design matrix implementing a cost function which may be used in a fourth embodiment; and
Figure 10 is an error budget diagram for two exposures in two layers of a substrate determined according to an embodiment.

DETAILED DESCRIPTION OF EXEMPLARY EMBODIMENTS

Before describing embodiments of the invention in detail, it is instructive to present an example environment in which embodiments of the present invention may be implemented.

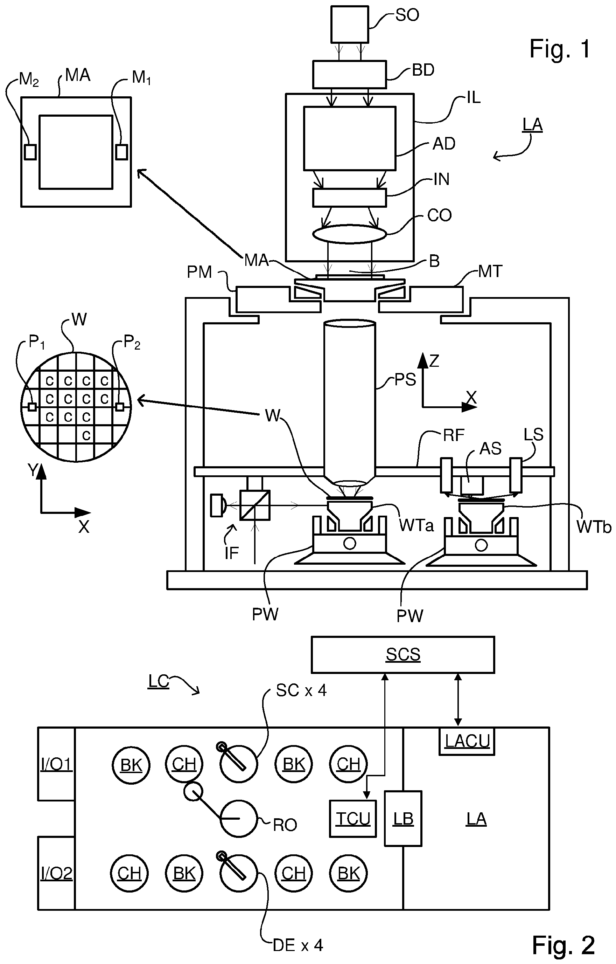

Figure 1 schematically depicts a lithographic apparatus LA. The apparatus includes an illumination optical system (illuminator) IL configured to condition a radiation beam B (e.g., UV radiation or DUV radiation), a patterning device support or support structure (e.g., a mask table) MT constructed to support a patterning device (e.g., a mask) MA and connected to a first positioner PM configured to accurately position the patterning device in accordance with certain parameters; a substrate table (e.g., a wafer table) WT constructed to hold a substrate (e.g., a resist coated wafer) W and connected to a second positioner PW configured to accurately position the substrate in accordance with certain parameters; and a projection optical system (e.g., a refractive projection lens system) PS configured to project a pattern imparted to the radiation beam B by patterning device MA onto a target portion C (e.g., including one or more dies) of the substrate W.

The illumination optical system may include various types of optical components, such as refractive, reflective, magnetic, electromagnetic, electrostatic or other types of optical components, or any combination thereof, for directing, shaping, or controlling radiation.

The patterning device support holds the patterning device in a manner that depends on the orientation of the patterning device, the design of the lithographic apparatus, and other conditions, such as for example whether or not the patterning device is held in a vacuum environment. The patterning device support can use mechanical, vacuum, electrostatic or other clamping techniques to hold the patterning device. The patterning device support may be a frame or a table, for example, which may be fixed or movable as required. The patterning device support may ensure that the patterning device is at a desired position, for example with respect to the projection system. Any use of the terms "reticle" or "mask" herein may be considered synonymous with the more general term "patterning device."

The term "patterning device" used herein should be broadly interpreted as referring to any device that can be used to impart a radiation beam with a pattern in its cross-section such as to create a pattern in a target portion of the substrate. It should be noted that the pattern imparted to the radiation beam may not exactly correspond to the desired pattern in the target portion of the substrate, for example if the pattern includes phase-shifting features or so called assist features. Generally, the pattern imparted to the radiation beam will correspond to a particular functional layer in a device being created in the target portion, such as an integrated circuit.

The patterning device may be transmissive or reflective. Examples of patterning devices include masks, programmable mirror arrays, and programmable LCD panels. Masks are well known in lithography, and include mask types such as binary, alternating phase-shift, and attenuated phase-shift, as well as various hybrid mask types. An example of a programmable mirror array employs a matrix arrangement of small mirrors, each of which can be individually tilted so as to reflect an incoming radiation beam in different directions. The tilted mirrors impart a pattern in a radiation beam, which is reflected by the mirror matrix.

As here depicted, the apparatus is of a transmissive type (e.g., employing a transmissive mask). Alternatively, the apparatus may be of a reflective type (e.g., employing a programmable mirror array of a type as referred to above, or employing a reflective mask).

The lithographic apparatus may also be of a type wherein at least a portion of the substrate may be covered by a liquid having a relatively high refractive index, e.g., water, so as to fill a space between the projection system and the substrate. An immersion liquid may also be applied to other spaces in the lithographic apparatus, for example, between the mask and the projection system. Immersion techniques are well known in the art for increasing the numerical aperture of projection systems. The term "immersion" as used herein does not mean that a structure, such as a substrate, must be submerged in liquid, but rather only means that liquid is located between the projection system and the substrate during exposure.

Referring to Figure 1, the illuminator IL receives a radiation beam from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD including, for example, suitable directing mirrors and/or a beam expander. In other cases the source may be an integral part of the lithographic apparatus, for example when the source is a mercury lamp. The source SO and the illuminator IL, together with the beam delivery system BD if required, may be referred to as a radiation system.

The illuminator IL may include an adjuster AD for adjusting the angular intensity distribution of the radiation beam. Generally, at least the outer and/or inner radial extent (commonly referred to as σ-outer and σ-inner, respectively) of the intensity distribution in a pupil plane of the illuminator can be adjusted. In addition, the illuminator IL may include various other components, such as an integrator IN and a condenser CO. The illuminator may be used to condition the radiation beam, to have a desired uniformity and intensity distribution in its cross section.

The radiation beam B is incident on the patterning device (e.g., mask) MA, which is held on the patterning device support (e.g., mask table MT), and is patterned by the patterning device. Having traversed the patterning device (e.g., mask) MA, the radiation beam B passes through the projection optical system PS, which focuses the beam onto a target portion C of the substrate W, thereby projecting an image of the pattern on the target portion C. With the aid of the second positioner PW and position sensor IF (e.g., an interferometric device, linear encoder, 2-D encoder or capacitive sensor), the substrate table WT can be moved accurately, e.g., so as to position different target portions C in the path of the radiation beam B. Similarly, the first positioner PM and another position sensor (which is not explicitly depicted in Figure 1) can be used to accurately position the patterning device (e.g., mask) MA with respect to the path of the radiation beam B, e.g., after mechanical retrieval from a mask library, or during a scan.

Patterning device (e.g., mask) MA and substrate W may be aligned using mask alignment marks M1, M2 and substrate alignment marks P1, P2. Although the substrate alignment marks as illustrated occupy dedicated target portions, they may be located in spaces between target portions (these are known as scribe-lane alignment marks). Similarly, in situations in which more than one die is provided on the patterning device (e.g., mask) MA, the mask alignment marks may be located between the dies. Small alignment markers may also be included within dies, in amongst the device features, in which case it is desirable that the markers be as small as possible and not require any different imaging or process conditions than adjacent features. The alignment system, which detects the alignment markers is described further below.

Lithographic apparatus LA in this example is of a so-called dual stage type which has two substrate tables WTa, WTb and two stations - an exposure station and a measurement station - between which the substrate tables can be exchanged. While one substrate on one substrate table is being exposed at the exposure station, another substrate can be loaded onto the other substrate table at the measurement station and various preparatory steps carried out. The preparatory steps may include mapping the surface control of the substrate using a level sensor LS and measuring the position of alignment markers on the substrate using an alignment sensor AS. This enables a substantial increase in the throughput of the apparatus.

The depicted apparatus can be used in a variety of modes, including for example a step mode or a scan mode. The construction and operation of lithographic apparatus is well known to those skilled in the art and need not be described further for an understanding of the present invention.

As shown in Figure 2, the lithographic apparatus LA forms part of a lithographic system, referred to as a lithographic cell LC or a lithocell or cluster. The lithographic cell LC may also include apparatus to perform pre- and post-exposure processes on a substrate. Conventionally these include spin coaters SC to deposit resist layers, developers DE to develop exposed resist, chill plates CH and bake plates BK. A substrate handler, or robot, RO picks up substrates from input/output ports I/O1, I/O2, moves them between the different process apparatus and delivers then to the loading bay LB of the lithographic apparatus. These devices, which are often collectively referred to as the track, are under the control of a track control unit TCU which is itself controlled by the supervisory control system SCS, which also controls the lithographic apparatus via lithography control unit LACU. Thus, the different apparatus can be operated to maximize throughput and processing efficiency.

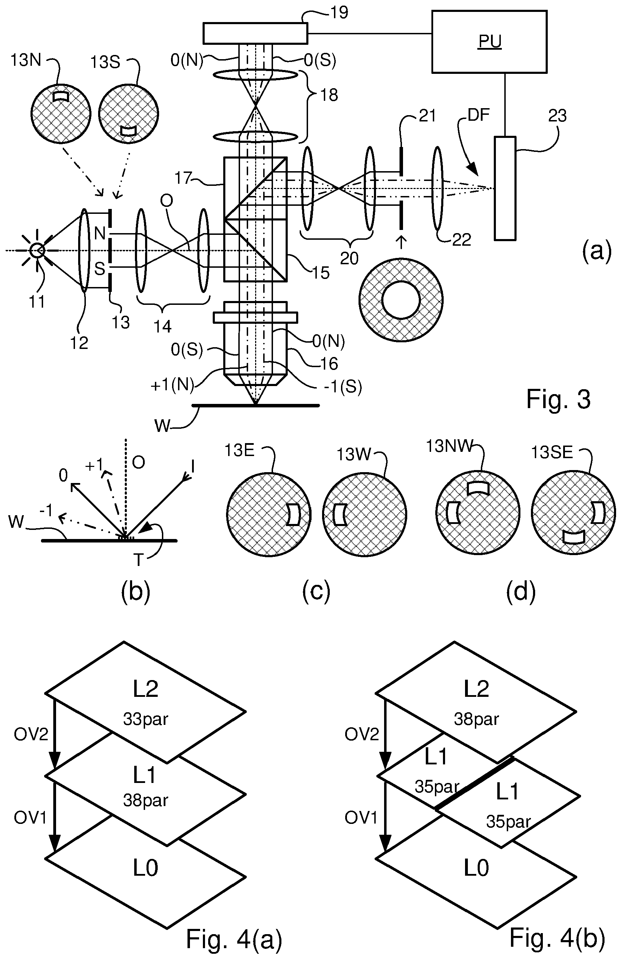

A metrology apparatus suitable for use in embodiments of the invention is shown in Figure 3(a). A target T and diffracted rays of measurement radiation used to illuminate the target are illustrated in more detail in Figure 3(b). The metrology apparatus illustrated is of a type known as a dark field metrology apparatus. The metrology apparatus may be a stand-alone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures, such as those which enable simultaneous illumination and detection from two opposing directions in combination with optical wedges to separate the resultant images. The rest of the pupil plane is desirably dark as any unnecessary light outside the desired illumination mode will interfere with the desired measurement signals.

As shown in Figure 3(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 3(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 3(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled -1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 3 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 3) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 3(c) and (d). The use of these, and numerous other variations and applications of the apparatus are described in prior published applications, mentioned above.

It is known to use an apparatus such as illustrated in Figure 3(a) to measure overlay. To achieve this, overlay targets may be printed on a wafer in two layers. One method of overlay metrology (sometimes referred to as micro-diffraction based overlay (μDBO) infers overlay from an asymmetry imbalance in complementary diffraction orders from targets comprising a respective grating in each layer. Typically, in μDBO the gratings have the same single pitch in each layer, though there may be an imposed bias between the two targets.

The performance of a lithographic apparatus is conventionally controlled and corrected by methods such as advanced process control (APC) described for example in US2012008127A1, incorporated herein by reference. The advanced process control techniques may use measurements of metrology targets applied to the substrate. A Manufacturing Execution System (MES) may schedule the APC measurements and communicate the measurement results to a data processing unit. The data processing unit may translate the characteristics of the measurement data to a recipe comprising instructions for the lithographic apparatus. This method is very effective in suppressing drift phenomena associated with the lithographic apparatus.

The APC process applies correction in a feedback loop. The APC corrections are set of distortion modeling parameters or correction parameters, sometimes referred to as k-parameters, defined per field of each substrate, i.e. wafer, within a lot. These parameters parameterize the distortion of the imaging across the field of each substrate. For example each correction parameter could describe a certain image distortion component such as one or more of: scaling error, barrel distortion, pincushion distortion, etc. The correction parameters can are also used as input to the lithographic system (scanner) to correct the distortion. Each of these correction parameters may be returned to the scanner by the feedback loop and used to correct the parameters of an associated part of the scanner (e.g. lens, wafer stage, reticle stage) so as to minimize a parameter of interest.

Different models of lithographic apparatus may have different correction capabilities, and as such one apparatus model may provide more correction actuations than another model. The different correction capabilities may be described in terms of the number of these correction parameters or k-parameters available to each type of lithographic apparatus for modeling distortion and therefore for correcting this distortion. By way of specific example, one type of DUV scanner provides 38 parameter correction capability while one type of EUV scanner provides 35 parameter correction capability.

An issue arises when lithographic apparatuses having different correction capabilities are used to expose different layers of the same device. This may be done for various reasons including using more advanced apparatuses for layers with stricter tolerances, while layers with less strict tolerances can be exposed on less advanced apparatuses. In particular, an issue may arise when an upper layer is exposed using an apparatus with a different (e.g., more limited) correction capability than that used to expose a preceding layer.

Figure 4(a) illustrates such an arrangement. It shows three fields (each rectangle) exposed in respective layers, a base layer L0, a first layer L1 and a second layer L2. The first layer L1 is exposed using an apparatus having 38 parameter correction capability (35 parameter correction per exposure CPE) and the second layer L2 is exposed using an apparatus having 33 parameter correction capability (33 parameter CPE). The correction capability of the tool used to expose this layer is not important for this analysis, it may be the same tool as used to expose layer L1 for example. Two overlays are shown, a first overlay OV1 between layer L0 and L1 and a second overlay OV2 between layer L1 and L2.

Another issue may arise when one layer is exposed in multiple sub-exposures. Such sub-exposures are proposed for high-NA EUV lithographic apparatuses for example. Figure 4(b) illustrates such an arrangement. It shows three layers, a base layer L0, a first layer L1 and a second layer L2. The first layer L1 comprises two sub-fields exposed in two sub-exposures using an apparatus having 35 parameter correction capability (35 parameter CPE) and the second layer L2 is exposed (as a single field in a single exposure) using an apparatus having 38 parameter correction capability (38 parameter CPE). The correction capability of the tool used to expose the second layer is not important for this analysis, it may be the same tool or at least have the same correction capability as the tool used to expose layer L2 for example. Two overlays are shown, a first overlay OV1 between layer L0 and L1 and a second overlay OV2 between layer L1 and L2.

Note that the first layer and second layer may be swapped in the context of this disclosure, e.g., such that the first layer is exposed using an apparatus having 38 parameter correction capability, and the second layer comprises two sub-fields exposed in two sub-exposures using an apparatus having 35 parameter correction capability. Because some of the parameters in the first layer are not available in the second layer, such an arrangement may still benefit from the methods disclosed.

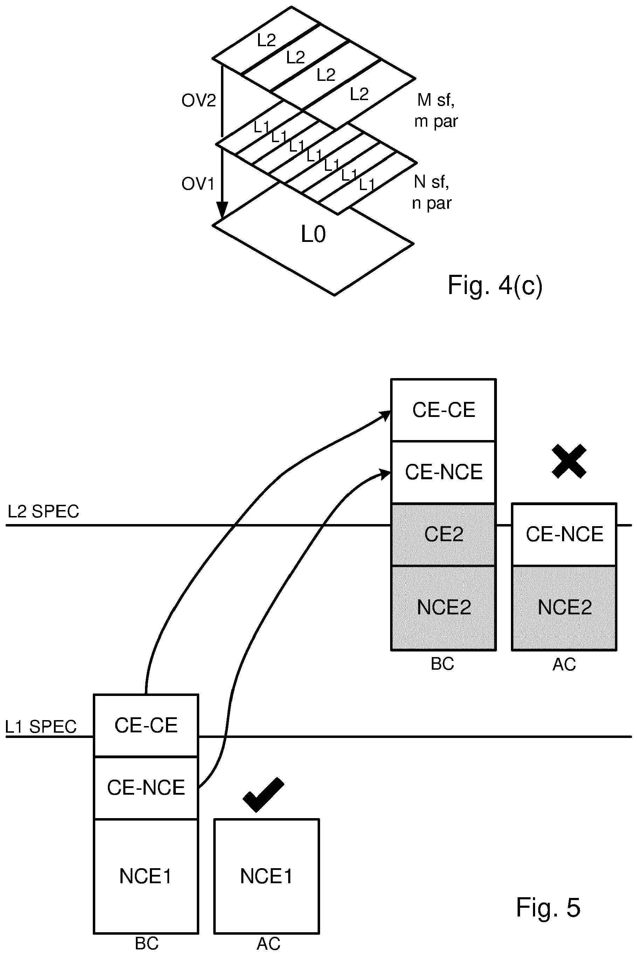

The arrangements illustrated in Figures 4(a) and 4(b) may be generalized in the arrangement of Figure 4(c), where the first layer L1 is exposed in $N(\geq 1)$ sub-exposures (sub-fields) using an apparatus with n parameter correction capability and the second layer L2 is exposed in $M(\geq 1)$ sub-exposures (sub-fields) using an apparatus with m parameter correction capability, where $n \neq m$ and/or $N \neq M$ and such that the correction capability of layer L2 is different (e.g., more limited) than that of layer L1. Note that a field can be divided in x direction in addition to or instead of y direction. It can also be appreciated that, assuming similar correction capabilities for each sub-exposure, it may be that the proposed method does not really confer a benefit when $M = a * N$ and $a$ is an integer, as in such a case the correctable error fingerprint of the first layer is fully correctable in the second layer.

Figure 5 is an error budget diagram illustrating the problem which may be encountered with arrangements such as illustrated in Figures 4(a)-4(c). For example, considering the situation of Figure 4(a), where the first layer L1 is exposed in a first exposure with a first correction capability (e.g., a 38 parameter correction capability) and the second first layer L2 is exposed in a second exposure with a second correction capability (e.g., a with 33 parameter correction capability). A first exposure error budget of this exposure before correction BC can be divided into a first layer non-correctable error component NCE1 (first layer non-correctable fingerprint) and a first layer correctable error component (first layer correctable fingerprint).

The first layer correctable error component can be further divided into a first portion of said first layer correctable error component or CE-NCE component and a second portion of said first layer correctable error component or CE-CE component. The CE-NCE component may comprise a component of the first parameter of interest data which is correctable according to the first correction capability but is not correctable according to the second correction capability. The CE-CE component may comprise a component of the first parameter of interest data which is correctable according to the first correction capability and the second correction capability.

The CE-NCE component results from the different correction capabilities of the scanners used in each layer; e.g., using the Figure 4(a) example, CE-NCE is described by the 5 parameters which are comprised in the 38 parameter correction capability of the layer L1 scanner but not comprised in the 33 parameter correction capability of the layer L2 scanner (assuming that the other 33 parameters are common for the two scanners). As such, the CE-CE component is described by the common 33 parameters.

The CE-CE component and CE-NCE component each propagate to a second layer L2 where a further exposure is performed. The second layer exposure corresponds to an associated error budget (before correction) comprising second layer non-correctable fingerprint NCE2, second layer correctable fingerprint CE2 and the first layer correctable fingerprint (i.e., the combination of the CE-CE component and CE-NCE component) propagating from the previous layer.

The consequence of this is shown in the after correction AC first exposure error budget and AC second exposure error budget (e.g., for layer L1 and layer L2 respectively) with respect to a respective specification threshold L1 SPEC, L2 SPEC for that layer. In the first layer, the first layer correctable error CE-CE + CE-NCE is corrected (e.g., by an APC loop) leaving the first layer non-correctable fingerprint NCE1 which is below the first layer specification threshold L1 SPEC. However, after correction in layer L2, the combination of the second layer non-correctable fingerprint NCE2 and the CE-NCE component, which is non-correctable by the scanner used in this layer, results in a total non-correctable error fingerprint for this layer which exceeds the second layer specification threshold L2 SPEC. This assumes that the first layer error fingerprint is corrected using the full first correction capability for that layer L1.

The same essential issue arises with the arrangement of Figures 4(b) and 4(c). In Figure 4(b), where first layer L1 is exposed with two subfields using 35 parameters, there will either be a fingerprint discontinuity at the boundary of two subfields (which is undesirable) or a fingerprint with increased order (effectively comprising twice the 35 parameters). In this case, despite the second layer scanner comprising a greater correction capability than the first layer scanner, this discontinuity and/or increased fingerprint order results in a correctable error component CE-NCE which is correctable in the first layer but not the second layer and which propagates to the second layer (i.e., the correction capability of the full first exposure is greater than that of the second exposure due to the second exposure comprising sub-exposures).

Presently, any correctable error component CE-NCE which is correctable in a first layer but not a second layer is controlled by either not correcting non-common parameters or partially correcting this fingerprint with a reduced magnitude of parameters. These approaches compromise the performance of the first layer so as to reduce non-correctable error of the second layer (in a non-ideal way). In particular, for these two approaches, there has been no methodology to determine which parameters to exclude for bottom layer correction or how much these parameters need to be constrained. Not only this, but even if a certain parameter is completely removed, the correction fingerprint is not fully optimized due to crosstalk (which is either ignored or poorly handled).

To address this, methods are described herein which enable mathematically defining correctable error CE content of the first layer and decomposing this in terms of the second layer correctability; i.e., defining algebraically a CE-CE component and a CE-NCE component.

Such methods may comprise defining a design matrix and a similarity matrix in a way that CE-CE component remains constant (e.g., under a certain condition) and such that the CE-NCE component can be divided in a configurable manner into a first sub-portion CE-NCEa of said CE-NCE component (i.e., a first sub-portion of said first portion of said first layer correctable error component) and a second sub-portion CE-NCEb of said CE-NCE component (i.e., a second sub-portion of said first portion of said first layer correctable error component), with each sub-portion then attributed to the error budget of the first layer and second layer respectively. This may be achieved by varying and/or determining a weight of the similarity matrix. For example, the weight may define a parameterization which is a tradeoff between the first layer performance (e.g., in terms of a parameter of interest such as overlay) with respect to the second layer performance. As such, performance of the first layer and second layer may be simulated for different weightings and selected or optimized to ensure specifications of both (or more) layers are met.

The proposed method may mathematically define the optimal set of parameters without manual parameter selection or adjustment for the given multi-subfields layers combination. For example, where certain parameters are correctable in a first layer in each of two sub-fields, but cannot be corrected in a second layer without boundary discontinuity, e.g. due to the second layer being exposed as a single field (even when the second layer scanner has more parameters overall), the proposed method can automatically suppress these parameters without human intervention while taking parameter crosstalk into account.

Also, the proposed methods allow second layer overlay performance to be optimized indirectly by controlling the first layer overlay without having second layer overlay metrology or disturbing its APC trend under a certain condition.

The proposed method may comprise constructing a cost function comprising a combination (e.g., sum or &operator as explained below) of a first term comprising a first layer residual (non-correctable error component) of first layer parameter of interest data (e.g., overlay data) following correction and a second term comprising a weighted difference of a correctable error component of the first layer parameter of interest data described in terms of the parameter definition of the first layer and the same first layer parameter of interest data described in terms of the parameter definition of the second layer. As such the second term may be a weighted correctable error component of the first layer parameter of interest data described in terms of the difference in parameter definition between the two layers. Such a cost function may be minimized (e.g., a root-mean-square RMS minimization)

The proposed cost function may therefore take the form:

$$MinRMS\big((OV - OV_{CEL1}) \,\&\, W * (OV_{CEL2} - OV_{CEL1})\big)$$

where $OV$ is the first layer overlay (or other parameter of interest), $OV_{CEL1}$ is the first layer correctable error component of the first layer overlay as described in terms of the parameter definition of the first layer, $OV_{CEL2}$ is a further first layer correctable error component of the first layer overlay as described in terms of the parameter definition of the second layer and W is the weighting applied to the second term. The ampersand or &-operator indicates that the RMS is calculated over all the error values (i.e., both the layer 1 design matrix and weighted similarity matrix). By contrast, replacing this with a sum operator + (which is within the scope of this disclosure, as are other suitable combinations) calculates the sum of respective RMS values calculated separately from the two terms.

The weight balances these two terms. If the weight is zero, the correction parameters for the first layer purely minimizes the first layer residual while maximizing first layer CE-NCE fingerprint which is to propagate to the next layer, as is conventional. As the weight increases, the first layer fingerprint to be corrected by the first layer parameter definition increases in similarity to the first layer fingerprint to be corrected by the second layer parameter definition. This improves second layer performance by compromising the first layer performance.

The performance of the first layer and second layer can be simulated for a given weight. The solution vector comprises parameters for the both layers. The upper part comprises parameters describing the first layer overlay in terms of the second layer parameter definition. The lower part comprises the first layer overlay in terms of the first layer parameter definition. The first layer part of the solution can be evaluated as a correctable error fingerprint on the layout of the first layer. Subtracting this correctable error fingerprint from the first layer overlay provides simulated performance of the first layer.

Thus evaluated correctable error fingerprint may be fed to the second layer overlay when available and its correction can be re-calculated simulating its performance. Once the second layer has been exposed with some corrections, it is possible to re-simulate what would have happened if appropriate corrections had been applied. The final achieved performance for the second exposure does depend on the second exposures characteristics; this can ensure a limited level of penalty is introduced as a result of the first layer exposure. Alternatively, the parameters can be directly added to the second layer's ideal correction parameters in a linear manner where the layouts of two layers are the same. For example, when the CE-CE fingerprint is calculated from the first layer, the corresponding overlay vectors can be calculated with, e.g., a function $F(x, y)$ where $x$ & $y$ are coordinates. If the APC of the second layer is described as a function of $G(x, y)$, the new APC function will be $K(x, y) = F(x, y) + G(x, y)$ if the layouts of two layers (or coordinates) are same. If the coordinates are different, $F(x, y)$ can be first evaluated on the second layer's layout, the evaluated vectors added to the overlay of the second layer and parameters recalculated.

This design matrix can be solved either by a simple linear regression or using non-linear optimization techniques to obtain a solution within a machine actuation range.

The optimal weight can be defined by solving the cost function for different weights (e.g., simulating performance of each layer for different weights) while varying the weight, and evaluating the respective overlay performances of the two layers for each weight. The weight which provides best overlay performances of the two layers can be selected, or at least a weight which ensures both (or all) layer specifications are met may be selected.

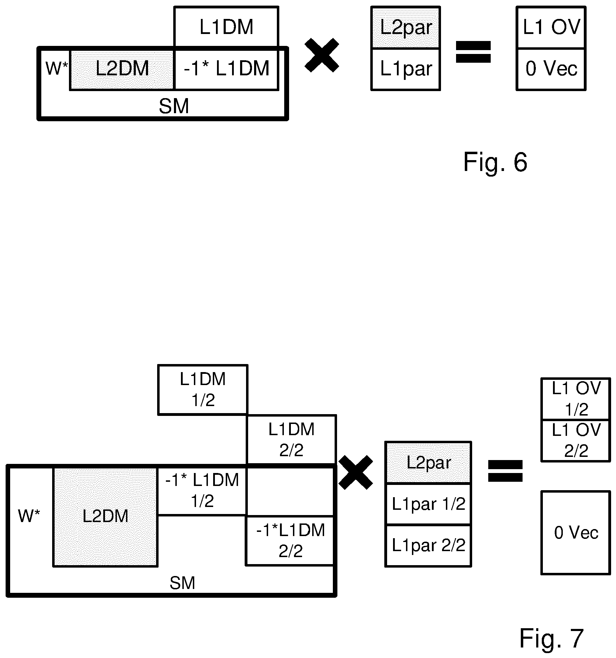

Figure 6 illustrates conceptually the design matrices which may be used in a specific embodiment such as that illustrated in Figure 4(a), i.e., a full-field exposure in each of the first layer L1 and second layer L2, but where the correction capability for the second layer is more limited than for the first layer. In a conventional treatment, the first layer design matrix L1DM (describing the first layer parameter definition with respect to the first layer fingerprint) is solved for the first layer parameter definition L1 par and first layer overlay data L1 OV as measured. In the proposed methods, a weighted W similarity matrix SM is also constructed comprising the weighted difference of a second layer design matrix L2DM and first layer design matrix L1DM. As such, the weighted similarity matrix corresponds to the second term of the cost function described above, and assesses the similarity of the first layer overlay fingerprint described in terms of the first layer parameter definition with respect to the first layer fingerprint described in terms of the second layer parameter definition.

The similarity matrix couples correctable contents of the first layer in terms of both layers' correctabilities. Increasing the weight reduces the CE-NCE portion of the fingerprint fed to the second layer reducing the NCE component of the second layer.

Figure 7 illustrates conceptually the design matrices which may be used in a specific embodiment such as that illustrated in Figure 4(b), i.e., two sub-field or half-field exposures in the first layer L1 and a full field exposure in the second layer L2, the correction capability of the different machines is not important, for example the correction capability for the first layer is more limited than for the second layer, or it may be equal. As can be seen the first layer design matrix now comprises a separate design matrix per sub-field L1DM 1/2, L1DM 2/2 (including in the similarity matrix SM) to determine a pair of correction fingerprints, separate parameter set L1par 1/2, L1par 2/2 and separate overlay data L1 OV 1/2, L1 OV 2/2. If the fingerprint of the first layer is over-corrected, there can be a discontinuity between two sub-fields or higher-order fingerprints which cannot be corrected by the correction capability of the second layer. By using the proposed method, the optimal amount of the first layer's correction fingerprint can be defined and used for correction. It can be appreciated that measurements on a same row of the design matrices should be from the same position. If measurements are aligned, coordinate systems do not necessarily need to be same.

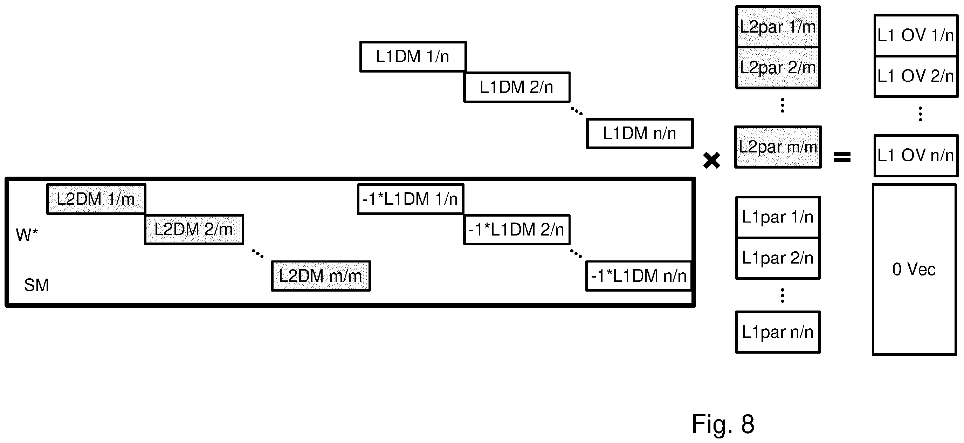

Figure 8 illustrates a generalized (two-layer) design matrix for a first layer comprising N sub-fields and having a n parameter correctability and a second layer comprising M sub-fields and having a m parameter correctability; e.g., such as that illustrated in Figure 4(c). In each layer, there is a separate design matrix L1DM 1/n - L1DM n/n, L2DM 1/m - L2DM m/m for each sub-field in that layer, and similarly separate parameter sets L1par 1/n - L1par n/n, L2par 1/m - L1par m/m and separate overlay data L1 OV 1/n - L1 OV n/n. This solution can be applicable to any layer combination with different layouts and/or correction capabilities

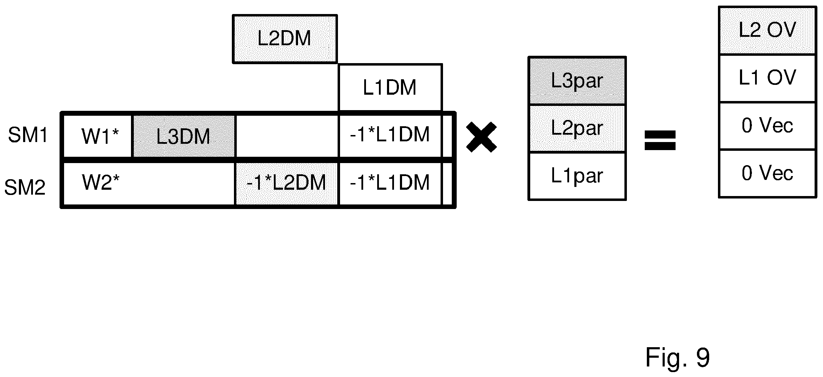

Figure 9 illustrates a further generalized design matrix for a three layer example with two overlays, although the basic concept may be extended to any number of layers/overlays. The solution can again be applicable to any layer combination with different layouts and/or correction capabilities (e.g., by extending each of the matrices as has been shown in Figure 8). Here there are two similarity matrices SM1, SM2, each with its own weight W1, W2. The first similarity matrix SM1 compares the third layer design matrix L3DM to the first layer design matrix L1DM. The second similarity matrix SM1 is the same as the previous examples. The third layer has an associated correction capability described by parameters L3 par. The measured data includes second layer overlay data L2 OV.

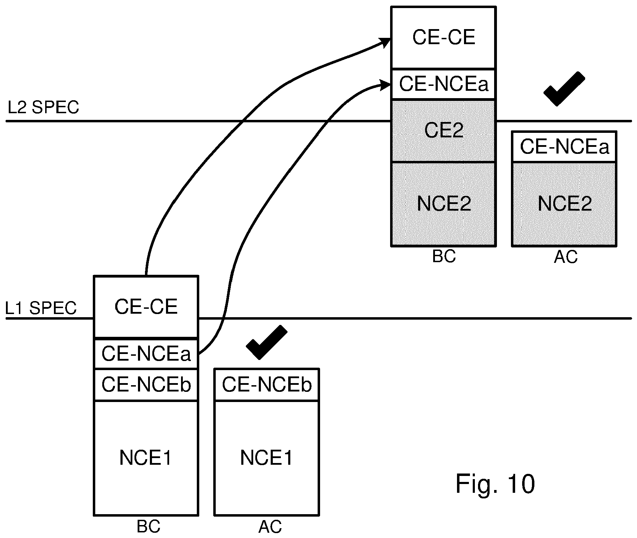

Figure 10 is an error budget diagram illustrating the effect of the method according to this embodiment. One thing to note is that, provided that the (e.g., linear) regression result does not exceed the actuation range, the CE-CE component remains constant for all weights (invariant with weight). This means that the correctable error for the second layer; i.e., the sum of CE-CE component and the correctable error CE2 of the second layer, is fixed regardless of the weight. This demonstrates that the proposed method can completely separate the CE-CE component and the CE-NCE component budgets. This means that updating the weight on the first layer does not affect APC content of the second layer.

The weighting serves to divide the CE-NCE component into two separate sub-portions or budgets CE-NCEa, CE-NCEb. The first sub-portion can be attributed to the second layer non-correctable error budget and the second sub-portion can be attributed to the first layer non-correctable error budget. The relative sizes of the sub-portions CE-NCEa, CE-NCEb are varied using the similarity matrix weight (the sum of these sub-portions will remain constant). As such, the methods as disclosed enable the CE-NCE component to be divided into two budgets mathematically and such that only a configurable sub-portion of it may be propagated to the next layer.

By varying the respective sizes of these sub-portions, the overall performance of the second layer can be traded off against that of the first layer and *vice versa.* This diagram may be compared to that of Figure 5, noting that the budgets are the same in both Figures 5 and 10 other than the division of CE-NCE into sub-portions CE-NCEa, CE-NCEb and propagation of only one sub-portion CE-NCEa to the second layer L2. In doing this, the total non-correctable component of the first layer is larger (representing worse performance) than it was in Figure 5 as it now comprises an additional sub-portion or component CE-NCEb in addition to NCE1. However this non-correctable component is still within specification L1 SPEC for the layer. The smaller sub-portion CE-NCEa of the CE-NCE component which is propagated to the second layer now means that the total non-correctable error (NCE2 + CE-NCEa) in the second layer is now within specification L2 SPEC for this layer.

In this manner, the method enables identification of which correctable parameter(s) from the first layer will become a non-correctable parameter(s) in the next layer via the similarity matrix. In such cases the parameter may be suppressed in the first layer. The suppression is not necessarily a per parameter suppression, as there may be combinations of parameters which alone would not be correctable in the second layer, but under a certain combination become correctable in the second layer (crosstalk effects) and therefore may still be used in the first layer. As such, the proposed method automatically adjusts parameters to optimize the balance between two layers. Depending on the first layer fingerprint, certain parameters of the first layer are suppressed or reduced while the second layer parameters remain constant.

It can be appreciated that the issues described here, and therefore the concepts disclosed below, applies not only in terms of field-to-field between two (or more) layers as has been described, but also to interfield, intrafield or other measurements/fingerprints which are taken from multiple layers having different respective correction capabilities. These different correction capabilities per layer may result from one or more of: different actuation potential of the respective lithographic apparatus, different number of sub-fields per field, different modeling strategies (e.g., alignment modeling) or correction strategies. As such it can be applied anywhere where correction capabilities differ per layer.

In the embodiments described above, only one weight is used in the optimization (per layer pair). However, multiple weights can be supported, e.g., to provide a different weight per region (e.g., per field region or per wafer region). For example, referring to the Figure 4(b) example, a greater weight may be applied near the stitch boundary of the two sub-fields (field center), than elsewhere to address boundary effects. Similarly, in an interfield setting, a greater weighting may be applied at a wafer boundary (edge fields) than the wafer center.

The specific examples given are only a few examples for which the methods disclosed herein are applicable. The concepts herein may be generally applicable to arrangements where correction capability is different for two (or more) layers. This may include when the second layer correctability is limited by the correctability of the first layer (e.g., the second layer correctability is more limited than the first layer). This also includes where the second layer correctability is greater than the first layer, but the first layer has more sub-fields. Also included is when the number of correction parameters for each layer is the same, but one or more of the actual parameters differ. For example, a particular parameter may be available for correction in the first layer but not the second. In such as case, where there is crosstalk between this parameter and other parameters present in the second layer correction set, the effect of this crosstalk may be leveraged by using the parameters which crosstalk with the missing parameter to at least partially effect a correction.

While the targets described above are metrology targets specifically designed and formed for the purposes of measurement, in other embodiments, properties may be measured on targets which are functional parts of devices formed on the substrate. Many devices have regular, grating-like structures. The terms 'target grating' and 'target' as used herein do not require that the structure has been provided specifically for the measurement being performed. Further, pitch P of the metrology targets is close to the resolution limit of the optical system of the scatterometer, but may be much larger than the dimension of typical product features made by lithographic process in the target portions C. In practice the lines and/or spaces of the overlay gratings within the targets may be made to include smaller structures similar in dimension to the product features.

In association with the physical grating structures of the targets as realized on substrates and patterning devices, an embodiment may include a computer program containing one or more sequences of machine-readable instructions describing methods of measuring targets on a substrate and/or analyzing measurements to obtain information about a lithographic process. This computer program may be executed for example within unit PU in the apparatus of Figure 3 and/or the control unit LACU of Figure 2. There may also be provided a data storage medium (e.g., semiconductor memory, magnetic or optical disk) having such a computer program stored therein. Where an existing metrology apparatus, for example of the type shown in Figure 3, is already in production and/or in use, the invention can be implemented by the provision of updated computer program products for causing a processor to perform the methods disclosed herein.

While the embodiments disclosed above are described in terms of diffraction based overlay measurements (e.g., measurements made using the second measurement branch of the apparatus shown in Figure 3(a)), in principle the same models can be used for pupil based overlay measurements (e.g., measurements made using the first measurement branch of the apparatus shown in Figure 3(a)). Consequently, it should be appreciated that the concepts described herein are equally applicable to diffraction based overlay measurements and pupil based overlay measurements.

Although specific reference may have been made above to the use of embodiments of the invention in the context of optical lithography, it will be appreciated that the invention may be used in other applications, for example imprint lithography, and where the context allows, is not limited to optical lithography. In imprint lithography a topography in a patterning device defines the pattern created on a substrate. The topography of the patterning device may be pressed into a layer of resist supplied to the substrate whereupon the resist is cured by applying electromagnetic radiation, heat, pressure or a combination thereof. The patterning device is moved out of the resist leaving a pattern in it after the resist is cured.

The terms "radiation" and "beam" used herein encompass all types of electromagnetic radiation, including ultraviolet (UV) radiation (e.g., having a wavelength of or about 365, 355, 248, 193, 157 or 126 nm) and extreme ultra-violet (EUV) radiation (e.g., having a wavelength in the range of 5-20 nm), as well as particle beams, such as ion beams or electron beams.

The term "lens", where the context allows, may refer to any one or combination of various types of optical components, including refractive, reflective, magnetic, electromagnetic and electrostatic optical components.

The foregoing description of the specific embodiments will so fully reveal the general nature of the invention that others can, by applying knowledge within the skill of the art, readily modify and/or adapt for various applications such specific embodiments, without undue experimentation, without departing from the general concept of the present invention. Therefore, such adaptations and modifications are intended to be within the meaning and range of equivalents of the disclosed embodiments, based on the teaching and guidance presented herein. It is to be understood that the phraseology or terminology herein is for the purpose of description by example, and not of limitation, such that the terminology or phraseology of the present specification is to be interpreted by the skilled artisan in light of the teachings and guidance.

The breadth and scope of the present invention should not be limited by any of the above-described exemplary embodiments, but should be defined only in accordance with the following claims and their equivalents.

The following numbered clauses describe embodiments of the disclosure:

1. A method of determining an exposure strategy for at least a first exposure in a first layer of a substrate with a first correction capability and at least a second exposure in a second layer of said substrate with a second correction capability, the second correction capability being different to the first correction capability, the method comprising:

obtaining first layer parameter of interest data relating to said first layer;
determining a first layer correctable error component of said first layer parameter of interest data, which is correctable according to said first correction capability;
determining a first portion of said first layer correctable error component, said first portion of said first layer correctable error component being correctable according to said first correction capability but uncorrectable according to said second correction capability;
dividing said first portion of said first layer correctable error into at least a first sub-portion of said first portion of said first layer correctable error component and a second sub-portion of said first portion of said first layer correctable error component; and
attributing said first sub-portion of said first portion of said first layer correctable error component to a first exposure error budget of said first exposure and said second sub-portion of said first portion of said first layer correctable error component to a second exposure error budget of said second exposure.

2. A method according to clause 1, further comprising, for said first exposure:

not determining a correction for said first sub-portion of said first portion of said first layer correctable error component; and

determining a correction for said second sub-portion of said first portion of said first layer correctable error component.

3. A method according to clause 1 or 2, wherein a difference in said second correction capability with respect to said first correction capability is at least partially a result of respective different correction capabilities of a first lithographic apparatus used to perform said first exposure and a second lithographic apparatus used to perform said second exposure.

4. A method according to any preceding clause, wherein a difference in said second correction capability with respect to said first correction capability is at least partially a result of at least said first exposure comprising a plurality of sub-exposures and said second exposure comprising a single exposure or fewer sub-exposures than said first exposure.

5. A method according to any preceding clause, wherein a difference in said second correction capability with respect to said first correction capability is at least partially a result of different respective models used to model an aspect of each said exposure.

6. A method according to any preceding clause, wherein said first exposure and said second exposure each comprises exposures of overlapping fields on said substrate.

7. A method according to any preceding clause, wherein said first correction capability is defined in terms of a first set of correction parameters and said second correction capability is defined in terms of a second set of correction parameters.

8. A method according to any preceding clause, comprising configuring the relative sizes of at least said first sub-portion and said second sub-portion.

9. A method according to clause 8, wherein said configuring step comprises determining at least one weight within a cost function.

10. A method according to clause 9, comprising constructing said cost function, wherein said cost function comprises:

a first term comprising a first layer non-correctable error component of said first layer parameter of interest data, which is uncorrectable according to said first correction capability;

a second term comprising at least a difference of said first layer correctable error component and a further first layer correctable error component, said further first layer correctable error component comprising a component of said first layer parameter of interest data which is correctable according to said second correction capability; and

said at least one weight for weighting said second term.

11. A method according to clause 10, wherein said second term is constructed as a similarity matrix weighted by said at least one weight.

12. A method according to clause 9, 10 or 11, comprising simulating performance of said first exposure and said second exposure by solving said cost function for various values of said at least one weight; and

evaluating performance of said first exposure and said second exposure for each said various values of said at least one weight.

13. A method according to any of clauses 9 to 12, comprising selecting a respective value for each said at least one weight for which both of said first exposure and said second exposure are within a set specification.

14. A method according to any of clauses 9 to 13, comprising selecting a respective value for each said at least one weight for which said first exposure and said second exposure together provide best performance for a parameter of interest.

15. A method according to any of clauses 9 to 14, wherein said at least one weight comprises a different weight for two or more different regions of said substrate and/or an exposure field thereof.

16. A method according to any of clauses 9 to 15 wherein exposure strategy relates to more than two exposures, each said exposure being in a different layer said at least one weight comprises a different weight for each of different pairs of said more than two exposures.

17. A method according to any of preceding clause, wherein said parameter of interest is overlay.

18. A method according to any of preceding clause, wherein said first exposure is to be performed before said second exposure.

19. A method according to any preceding clause, comprising performing said first and second exposure actions based on the first exposure error budget and the second exposure error budget.

20. A method according to any preceding clause, comprising performing said method without any second layer parameter of interest data relating to said second layer.

21. A computer program comprising program instructions operable to perform the method of any preceding clause, when run on a suitable apparatus.

22. A non-transient computer program carrier comprising the computer program of clause 21.

23. A processing arrangement comprising:

a non-transient computer program carrier comprising a computer program comprising program instructions operable to perform the method of any of clauses 1 to 20, when run on a suitable apparatus; and
a processor operable to run the computer program comprised on said non-transient computer program carrier.

24. A lithographic apparatus comprising:

a patterning device support for supporting a patterning device;
a substrate support for supporting the substrate;
a projection system operable to perform at least one of said first exposure and said second exposure; and
the processing arrangement of clause 23.

**Claims**

1. A method of determining an exposure strategy for at least a first exposure in a first layer of a substrate with a first correction capability and at least a second exposure in a second layer of said substrate with a second correction capability, the second correction capability being different to the first correction capability, the method comprising:

obtaining first layer parameter of interest data relating to said first layer;
determining a first layer correctable error component of said first layer parameter of interest data, which is correctable according to said first correction capability;
determining a first portion of said first layer correctable error component, said first portion of said first layer correctable error component being correctable according to said first correction capability but uncorrectable according to said second correction capability;
dividing said first portion of said first layer correctable error into at least a first sub-portion of said first portion of said first layer correctable error component and a second sub-portion of said first portion of said first layer correctable error component; and
attributing said first sub-portion of said first portion of said first layer correctable error component to a first exposure error budget of said first exposure and said second sub-portion of said first portion of said first layer correctable error component to a second exposure error budget of said second exposure.

2. A method as claimed in claim 1, further comprising, for said first exposure:

not determining a correction for said first sub-portion of said first portion of said first layer correctable error component; and
determining a correction for said second sub-portion of said first portion of said first layer correctable error component.

3. A method as claimed in claim 1 or 2, wherein a difference in said second correction capability with respect to said first correction capability is at least partially a result of respective different correction capabilities of a first lithographic apparatus used to perform said first exposure and a second lithographic apparatus used to perform said second exposure.

4. A method as claimed in any preceding claim, wherein a difference in said second correction capability with respect to said first correction capability is at least partially a result of at least said first exposure comprising a plurality of sub-exposures and said second exposure comprising a single exposure or fewer sub-exposures than said first exposure.

5. A method as claimed in any preceding claim, wherein a difference in said second correction capability with respect to said first correction capability is at least partially a result of different respective models used to model an aspect of each said exposure.

6. A method as claimed in any preceding claim, comprising:
configuring the relative sizes of at least said first sub-portion and said second sub-portion by determining at least one weight within a cost function.

7. A method as claimed in claim 6, comprising constructing said cost function, wherein said cost function comprises:

a first term comprising a first layer non-correctable error component of said first layer parameter of interest data, which is uncorrectable according to said first correction capability;

a second term comprising at least a difference of said first layer correctable error component and a further first layer correctable error component, said further first layer correctable error component comprising a component of said first layer parameter of interest data which is correctable according to said second correction capability; and said at least one weight for weighting said second term.

8. A method as claimed in claim 7, wherein said second term is constructed as a similarity matrix weighted by said at least one weight.

9. A method as claimed in claim 6, 7 or 8, comprising simulating performance of said first exposure and said second exposure by solving said cost function for various values of said at least one weight; and evaluating performance of said first exposure and said second exposure for each said various values of said at least one weight.

10. A method as claimed in any of claims 6 to 9, comprising selecting a respective value for each said at least one weight for which both of said first exposure and said second exposure are within a set specification.

11. A method as claimed in any of claims 6 to 10, comprising selecting a respective value for each said at least one weight for which said first exposure and said second exposure together provide best performance for a parameter of interest.

12. A method as claimed in any of claims 6 to 11, wherein said at least one weight comprises a different weight for two or more different regions of said substrate and/or an exposure field thereof.

13. A method as claimed in any of claims 6 to 12, wherein exposure strategy relates to more than two exposures, each said exposure being in a different layer said at least one weight comprises a different weight for each of different pairs of said more than two exposures.

14. A computer program comprising program instructions operable to perform the method of any preceding clause, when run on a suitable apparatus.

15. A processing arrangement comprising:

a non-transient computer program carrier comprising a computer program comprising program instructions operable to perform the method of any of claims 1 to 13, when run on a suitable apparatus; and a processor operable to run the computer program comprised on said non-transient computer program carrier.

Fig. 1

Fig. 2

Fig. 3

Fig. 4(a)

Fig. 4(b)

Fig. 4(c)

Fig. 5

L1DM

W* | L2DM | -1* L1DM
SM

✕

L2par
L1par

=

L1 OV
0 Vec

## Fig. 6

L1DM
1/2

L1DM
2/2

W* | L2DM | -1* L1DM
1/2

-1*L1DM
2/2
SM

✕

L2par
L1par 1/2
L1par 2/2

=

L1 OV
1/2
L1 OV
2/2

0 Vec

## Fig. 7

L1DM 1/n

L1DM 2/n

L1DM n/n

L2par 1/m

L2par 2/m

L2par m/m

L1 OV 1/n

L1 OV 2/n

L1 OV n/n

×

=

W*

L2DM 1/m

L2DM 2/m

L2DM m/m

-1*L1DM 1/n

-1*L1DM 2/n

-1*L1DM n/n

SM

L1par 1/n

L1par 2/n

L1par n/n

0 Vec

Fig. 8

L2DM

L1DM

| SM1 | W1* | L3DM | | -1*L1DM |
| --- | --- | --- | --- | --- |
| SM2 | W2* | | -1*L2DM | -1*L1DM |

✕

| L3par |
| --- |
| L2par |
| L1par |

=

| L2 OV |
| --- |
| L1 OV |
| 0 Vec |
| 0 Vec |

Fig. 9

Fig. 10

**EUROPEAN SEARCH REPORT**

Application Number

EP 23 19 3729

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2009/168034 A1 (STAECKER JENS [DE] ET AL) 2 July 2009 (2009-07-02) | 1-3,5-15 | INV.<br>G03F7/00 |
| Y | * paragraphs [0021] – [0027] *<br>* paragraphs [0045] – [0064]; figures 3,4 * | 4 | G03F9/00 |
| | ----- | | |
| X | EP 3 783 437 A1 (ASML NETHERLANDS BV [NL]) 24 February 2021 (2021-02-24)<br>* paragraphs [0026] – [0037]; figures 4,5 * | 1,14,15 | |
| | ----- | | |
| X | US 2011/213487 A1 (WAHLSTEN MIKAEL [SE] ET AL) 1 September 2011 (2011-09-01)<br>* paragraphs [0325] – [0333]; figures 23-28 *<br>* paragraph [0401] * | 1,14,15 | |
| | ----- | | |
| X | US 2020/081353 A1 (SIMONS HUBERTUS JOHANNES GERTRUDUS [NL] ET AL) 12 March 2020 (2020-03-12)<br>* paragraphs [0045] – [0046] *<br>* paragraph [0053] * | 1,14,15 | TECHNICAL FIELDS SEARCHED (IPC)<br><br>G03F |
| | ----- | | |
| X | US 2012/244461 A1 (NAGAI SATOSHI [US]) 27 September 2012 (2012-09-27)<br>* paragraphs [0032] – [0041]; figures 2,3 * | 1,14,15 | |
| | ----- | | |
| Y | US 2021/199596 A1 (ASANO KOSUKE [JP] ET AL) 1 July 2021 (2021-07-01)<br>* paragraph [0090]; figures 4A-C *<br>* paragraphs [0133] – [0134] * | 4 | |
| | ----- | | |

The present search report has been drawn up for all claims

| Place of search | Date of completion of the search | Examiner |
|---|---|---|
| Munich | 13 February 2024 | van Toledo, Wiebo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 19 3729

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2024

| Patent document cited in search report | | | Publication date | Patent family member(s) | | Publication date |
|---|---|---|---|---|---|---|
| US 2009168034 | A1 | | 02-07-2009 | NONE | | |
| EP 3783437 | A1 | | 24-02-2021 | NONE | | |
| US 2011213487 | A1 | | 01-09-2011 | CN | 102939565 A | 20-02-2013 |
| | | | | CN | 102959469 A | 06-03-2013 |
| | | | | CN | 102971674 A | 13-03-2013 |
| | | | | CN | 102985878 A | 20-03-2013 |
| | | | | CN | 103026299 A | 03-04-2013 |
| | | | | CN | 103097956 A | 08-05-2013 |
| | | | | EP | 2539773 A1 | 02-01-2013 |
| | | | | EP | 2539774 A1 | 02-01-2013 |
| | | | | EP | 2539775 A1 | 02-01-2013 |
| | | | | EP | 2539776 A1 | 02-01-2013 |
| | | | | EP | 2539777 A1 | 02-01-2013 |
| | | | | EP | 2539778 A1 | 02-01-2013 |
| | | | | JP | 5766725 B2 | 19-08-2015 |
| | | | | JP | 5767254 B2 | 19-08-2015 |
| | | | | JP | 5767255 B2 | 19-08-2015 |
| | | | | JP | 5784639 B2 | 24-09-2015 |
| | | | | JP | 5795777 B2 | 14-10-2015 |
| | | | | JP | 5873030 B2 | 01-03-2016 |
| | | | | JP | 2013520699 A | 06-06-2013 |
| | | | | JP | 2013520700 A | 06-06-2013 |
| | | | | JP | 2013520825 A | 06-06-2013 |
| | | | | JP | 2013520826 A | 06-06-2013 |
| | | | | JP | 2013520827 A | 06-06-2013 |
| | | | | JP | 2013520828 A | 06-06-2013 |
| | | | | KR | 20120120479 A | 01-11-2012 |
| | | | | KR | 20120123581 A | 08-11-2012 |
| | | | | KR | 20130004310 A | 09-01-2013 |
| | | | | KR | 20130004311 A | 09-01-2013 |
| | | | | KR | 20130004312 A | 09-01-2013 |
| | | | | KR | 20130052545 A | 22-05-2013 |
| | | | | KR | 20170120137 A | 30-10-2017 |
| | | | | KR | 20190018035 A | 20-02-2019 |
| | | | | US | 2011210104 A1 | 01-09-2011 |
| | | | | US | 2011213479 A1 | 01-09-2011 |
| | | | | US | 2011213484 A1 | 01-09-2011 |
| | | | | US | 2011213487 A1 | 01-09-2011 |
| | | | | US | 2011257777 A1 | 20-10-2011 |
| | | | | WO | 2011104372 A1 | 01-09-2011 |
| | | | | WO | 2011104373 A1 | 01-09-2011 |
| | | | | WO | 2011104374 A1 | 01-09-2011 |
| | | | | WO | 2011104375 A1 | 01-09-2011 |
| | | | | WO | 2011104376 A1 | 01-09-2011 |

EPO FORM P0459

For more details about this annex : see Official Journal of the European Patent Office, No. 12/82

page 1 of 2

## ANNEX TO THE EUROPEAN SEARCH REPORT
## ON EUROPEAN PATENT APPLICATION NO.

EP 23 19 3729

This annex lists the patent family members relating to the patent documents cited in the above-mentioned European search report.
The members are as contained in the European Patent Office EDP file on
The European Patent Office is in no way liable for these particulars which are merely given for the purpose of information.

13-02-2024

| Patent document cited in search report | Publication date | Patent family member(s) | | Publication date |
|---|---|---|---|---|
| | | WO | 2011113682 A1 | 22-09-2011 |
| US 2020081353 A1 | 12-03-2020 | CN | 110546575 A | 06-12-2019 |
| | | KR | 20190130020 A | 20-11-2019 |
| | | TW | 201907234 A | 16-02-2019 |
| | | US | 2020081353 A1 | 12-03-2020 |
| | | WO | 2018197146 A1 | 01-11-2018 |
| US 2012244461 A1 | 27-09-2012 | JP | 2012204833 A | 22-10-2012 |
| | | US | 2012244461 A1 | 27-09-2012 |
| US 2021199596 A1 | 01-07-2021 | JP | 2021107848 A | 29-07-2021 |
| | | US | 2021199596 A1 | 01-07-2021 |

EPO FORM P0459

For more details about this annex : see Official Journal of the European Patent Office, No. 12/82

page 2 of 2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2009078708 A
- WO 2009106279 A
- US 20110027704 A
- US 20110043791 A
- US 20120242940 A
- US 2012008127 A1